# EUROPÄISCHE PATENTANMELDUNG

(11) **EP 0 525 495 A1**
(43) Veröffentlichungstag der Anmeldung: **03.02.1993**
(21) Anmeldenummer: 92111911.1
(22) Anmeldetag: 13.07.1992
(51) Int. Cl.: H02M 3/10, H02M 3/22, H03K 3/017

(54) **Tiefsetzsteller**

(30) Priorität: 26.07.1991 DE 9109274 U
(71) Anmelder: SIEMENS AKTIENGESELLSCHAFT, D-80333 München (DE)
(72) Erfinder: Hofmann, Thomas, W-8520 Erlangen (DE); Segger, Bernd, Dipl.-Ing.(FH), W-8520 Erlangen (DE)

(57) **Zusammenfassung**

Der zum Takten erforderlichen Schalter (SCH) eines Tiefsetzstellers wird transformatorisch von einer Ansteuerschaltung mit Steuerimpulsen (5) beaufschlagt. Um das Puls-Perioden-Verhältnis der Steuerimpulsfolge (5) bis auf 100 % steigen zu können, wird die Speisung des Transformators (T2) im Gegentakt vorgenommen und das Ausgangssignal des Transformators (T2) gelangt über eine Vollweg-gleichrichterstufe (D3, D4) an den Schalter (SCH).

## Beschreibung

Die Erfindung bezieht sich auf einen Tiefsetzsteller, bei dem eine Eingangsgleichspannung über einen elektronischen Schalter getaktet wird, wobei die getaktete Spannung über Glättungsmittel in eine Ausgangsgleichspannung umgeformt wird, wobei die Ansteuerung des Schalters über eine Taktgeberstufe erfolgt, die ein Steuersignal mit einem entsprechend dem Tiefsetzfaktor einstellbaren Puls-Pausen-Verhältnis erzeugt und wobei dieses Steuersignal zwischen dem Schalter und der Taktgeberstufe über einen Transformator geführt wird, so daß eine galvanische Trennung erfolgt.

Derartige handelsübliche Tiefsetzsteller werden dazu benutzt, um beispielsweise aus Eingangssgleichspannungen von beispielsweise 600 Volt Ausgangsgleichspannungen von 100 Volt zu erzeugen. Schwankungen der jeweiligen Eingangsgleichspannung können dadurch ausgeglichen werden, daß das Puls-Perioden-Verhältnis, mit dem der elektronische Schalter getaktet wird, variert wird. Beim geschilderten Beispiel (600 V auf 100 V) könnte also ein Puls-Perioden-Verhältnis, das im Regelfall etwa 17 % beträgt, prinzipiell bis auf 100 % gesteigert werden, falls die am Eingang vorliegende Spannung bis auf 100 Volt zusammenbrechen sollte. Ein Puls-Perioden-Verhältnis von 100 % läßt sich jedoch bei den üblichen Tiefsetzstellern aus folgendem Grund nicht erreichen.

Die Ansteuerung des elektronischen Schalters erfolgt bei den bekannten Tiefsetzstellern über eine Taktgeberstufe, die auf relativ geringem Potential arbeitet und die deshalb galvanisch getrennt über einen Transformator die Ansteuerung des elektronischen Schalters veranlaßt. Nun ist jedoch bei einem Transformator die Übertragung eines Puls-Pausen-Signals nur dann möglich, wenn in Folge auf einen Puls die nächste Pause eine ausreichende magnetische Entregung des Transformators zuläßt. Demzufolge kann ein Puls-Perioden-Verhältnis von 100 % nicht realisiert werden und aus diesem Grund ist es auch nicht möglich, den Tiefsetzsteller auch mit sehr nahe der Ausgangsspannung liegenden Eingangsspannungen ordnungsgerecht zu betreiben.

Aufgabe der Erfindung ist es, einen Tiefsetzsteller der eingangs genannten Art so auszubilden, daß Steuersignale für den elektronischen Schalter mit einem Puls-Perioden-Verhältnis von bis zu 100 % gebildet werden können.

Gemäß der Erfindung wird diese Aufgabe dadurch gelöst, daß der Transformator von der Taktgeberstufe mit zwei Impulsfolgen im Gegentakt angesteuert wird, deren Puls-Perioden-Verhältnis zwischen 0 und 50 % einstellbar ist und daß das Ausgangssignal des Transformators über eine Vollweg-Gleichrichterstufe das Steuersignal mit einem Puls-Perioden-Verhältnis von 0 bi 100 % bildet.

Eine erste vorteilhafte Ausbildung der Erfindung ist dadurch gekennzeichnet, daß die beiden Impulsfolgen über zwei Primärwicklungsteile, die eine gemeinsame Mittenanzapfung aufweisen können, dem Transformator zugeleitet werden. Diese wicklungstechnische Maßnahme am Transformator bedingt nur einen sehr geringen Aufwand und erspart einen höheren Bauteileaufwand bei der Ansteuerung des Transformators.

Dadurch, daß die Vollweg-Gleichrichtung durch eine Mittelpunktschaltung bewerkstelligt ist, wird auch hierbei der Aufwand für die Gleichrichterlemente reduziert.

Eine weitere vorteilhafte Ausbildung der Erfindung ist dadurch gekennzeichnet, daß ein Lastwiderstand am Ausgang der Gleichrichterstufe vorgesehen ist. Damit wird mit Sicherheit die Entregung des Transformators gewährleistet.

Ein Ausführungsbeispiel der Erfindung ist in der Zeichnung dargestellt und wird im folgenden näher erläutert. Dabei zeigen:
FIG 1 ein Schaltbild der Erfindung,
FIG 2 signifikante Signalverläufe und
FIG 3 ein Blockschaltbild für einen handelsüblichen Tiefsetzsteller.

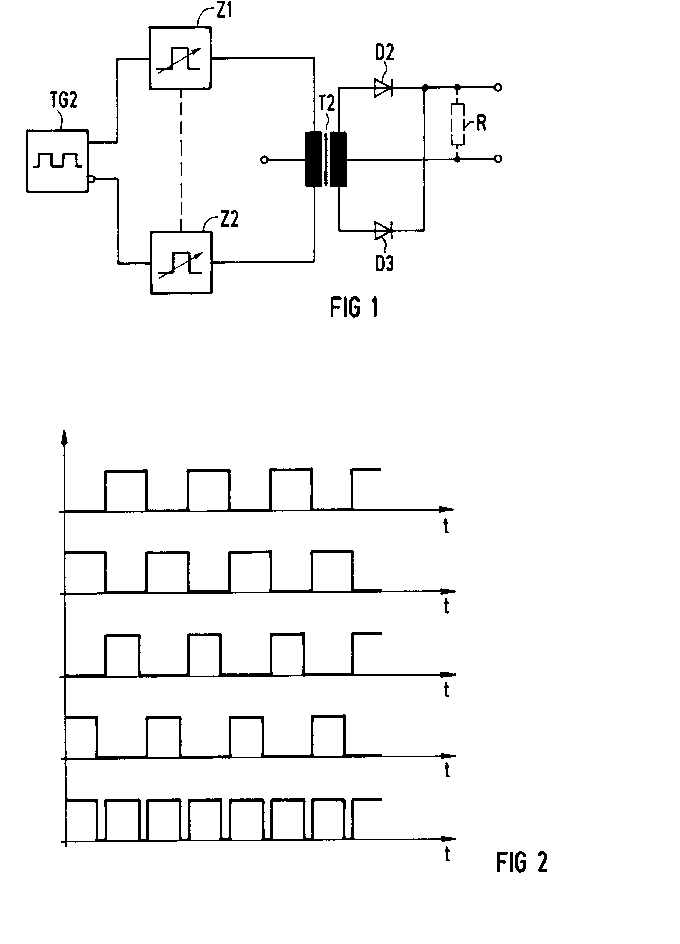

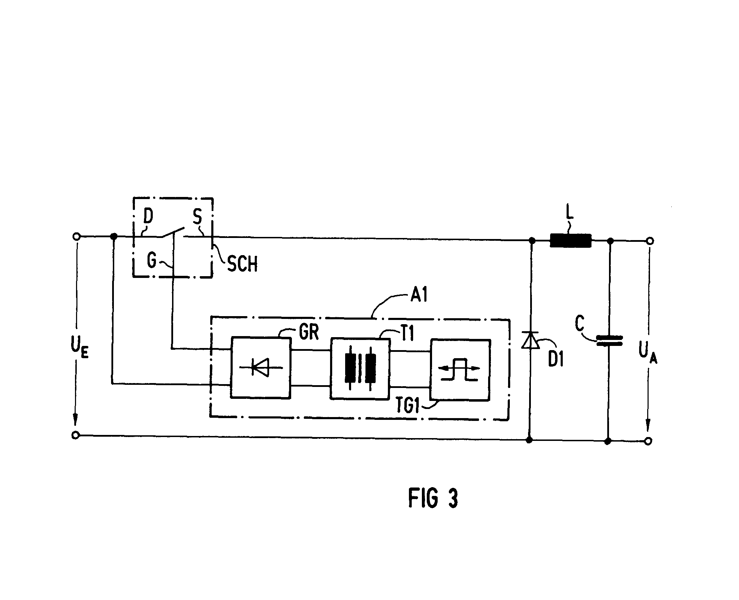

In der Darstellung gemäß FIG 1 wird in Form eines Blockschaltbildes das Prinzip eines erfindungsgemäßen Tiefsetzstellers geschildert, dessen signifikante Signalverläufe in der Darstellung gemäß FIG 2 gezeigt sind. Zur Erläuterung der Erfindung wird jedoch zunächst auf FIG 3 Bezug genommen, die das Prinzip eines handelsüblichen Tiefsetzstellers verdeutlicht.

In der Darstellung gemäß FIG 3 wird eine Eingangsgleichspannung U_{E} einem elektronischen Schalter SCH zugeleitet, bei dem es sich beispielsweise um einen MOS-Transistor handelt. Dies ist im gestrichelten Symbol für den Schalter SCH dadurch angedeutet, daß dort mit D der Drain-, mit S der Source- und mit G der Gate-Anschluß des MOS-Transistors bezeichnet ist. Der Ausgang des elektronischen Schalters SCH führt an ein Glättungsglied, das aus einer Induktivität L, einem Kondensator C sowie einer Freilaufdiode D1 besteht. Damit liegt am Ausgang der Schaltung eine Ausgangsgleichspannung U_{A} vor, die durch das Puls-Pausen- Verhältnis bzw. Puls-Perioden-Verhältnis bestimmt wird, mit dem der elektronische Schalter SCH gesteuert wird.

Die Ansteuerung des Schalters SCH wird von einem Taktgeber TG1 veranlaßt, der ein Puls-Perioden-Verhältnis von beispielsweise 0 bis etwa 90 % vorgeben kann, wobei dieser Taktgeber TG1 auf einem wesentlich niedrigeren Potential arbeitet, als dieses am elektronischen Schalter SCH ansteht. Demzufolge wird das Ausgangssignal des Taktgebers TG1 zum Zwecke einer galvanischen Trennung über einen Transformator T1 und einen Gleichrichter GR an den Gate-Anschluß G und den Drain-Anschluß D des MOS-Transistors SCH geleitet. Die Zusammenschaltung von Taktgeber TG1, Transformator T1 und Gleichrichter GR ist in der Darstellung gestrichelt als Ansteuerschaltung A1 zusammengefaßt. Bei dieser Schaltung kann das Puls-Perioden-Verhältnis deshalb nicht beliebig nahe gegen 100 % geführt werden, weil in diesem Fall der Transformator T1 in Sättigung gehen würde.

In der Darstellung gemäß FIG 1 ist eine Ansteuerschaltung gezeigt, die bei der Erfindung an die Stelle der Ansteuerschaltung A1 gemäß FIG 3 tritt. Bei dieser Schaltung wird vom Gegentaktprinzip zur Ansteuerung eines Transformators T2 Gebrauch gemacht, d.h., in einem ersten Halbtakt, der von einem Taktgeber TG2 bestimmt wird, wird jeweils eine erste Wicklungshälfte einer Primärwicklung des Transformators T2 mit einem Puls-Perioden-Verhältnis von 0 bis 50 % über ein Zeitglied Z1 angesteuert und in einem zweiten Halbtakt wird invers über ein Zeitglied Z2 ebenfalls mit einem Puls-Perioden-Verhältnis von 0 bis 50 % die zweite Wicklungshälfe der Primärwicklung des Transformators T2 angesteuert. Das Ausgangssignal des Transformators T2 wird dann einer Vollweggleichrichtung unterzogen und kann daraufhin an den elektronischen Schalter SCH weitergeleitet werden. Bedarfsweise kann der Ausgang der Gleichrichterstufe, in diesem Fall eine Anordnung zweier Dioden D2 und D3 in Mittelpunktschaltung, mit einem Widerstand R (gestrichelt angedeutet) belastet werden, damit stets eine sichere Entregung des Transformators T2 gewährleistet ist. Die signifikanten Signalverläufe der Schaltung gemäß FIG 1 sind mit 1, 2, 3, 4 und 5 bezeichnet und in der Darstellung gemäß FIG 2 zur Zeit t korrespondierend dargestellt.

Die Diagramme gemaß FIG 2 zeigen im oberen Teil - mit 1 bezeichnet - das Ausgangssignal des Taktgebers TG2, wobei es sich bei diesem Signal um ein Taktsignal mit einem Puls-Pausen-Verhältnis von 1:1, d.h. einem Puls-Perioden-Verhältnis von 50 % handelt. Über das Zeitglied Z1 kann die Impulsfolge 1 hinsichtlich ihrer Pulse kontinuierlich so verkürzt werden, bis am Ausgang des Zeitgliedes Z1 die Pulse völlig unterdrückt sind. Beim Ausführungsbeispiel werden die Impulse um etwa 20 % verkürzt. Der resultierende Signalverlauf ist im Diagramm 3 von FIG 2 gezeigt.

In entsprechender Weise gelangt das zum Signal 1 inverse Signal als Signal 2 an das Zeitglied Z2 und auch dieses Zeitglied ist in der Lage, die Impulse des Signals 2 unverändert hindurchzulassen oder zu verkürzen. Das resultierende Ausgangssignal des Zeitgliedes Z2 ist als Signal 4 in der Darstellung gemäß FIG 2 gezeigt.

Wenn die Signale 3 und 4 über den Transformator T2 geleitet werden und dann gleichgerichtet werden, resultiert ein Signal 5, wie dieses unten in FIG 2 gezeigt ist. Dieses Signal 5 erfüllt die eingangs genannten Voraussetzungen und kann als Steuersignal für den elektronischen Schalter SCH verwendet werden.

## Patentansprüche

1. Tiefsetzsteller, bei dem eine Eingangsgleichspannung über einen elektronischen Schalter getaktet wird, wobei die getaktete Spannung über Glättungsmittel in eine Ausgangsgleichspannung umgeformt wird, wobei die Ansteuerung des Schalters über eine Taktgeberstufe erfolgt, die ein Steuersignal mit einem entsprechend dem Tiefsetzfaktor einstellbaren Puls-Pausen-Verhältnis erzeugt und wobei dieses Steuersignal zwischen dem Schalter und der Taktgeberstufe über einen Transformator geführt wird, so daß eine galvanische Trennung erfolgt, dadurch gekennzeichnet, daß der Transformator (T2) von der Taktgeberstufe mit zwei Impulsfolgen (3,4) im Gegenstakt angesteuert wird, deren Puls-Perioden-Verhältnis zwischen 0 und 50 % einstellbar ist und daß das Ausgangssignal des Transformators (T2) über eine Vollweg-Gleichrichterstufe (D3,D4) das Steuersignal (5) mit einem Puls-Perioden-Verhältnis von 0 bis 100 % bildet.

2. Tiefsetzsteller nach Anspruch 1, dadurch gekennzeichnet, daß die beiden Impulsfolgen (3,4) über zwei Primärwicklungsteile, die eine gemeinsame Mittenanzapfung aufweisen können, dem Transformator (T2) zugeleitet werden.

3. Tiefsetzsteller nach Anspruch 1 oder 2, dadurch gekennzeichnet, daß die Vollweg-gleichrichtung durch eine Mittelpunktschaltung (D3,D4) erfolgt.

4. Tiefsetzsteller nach Anspruch 1, 2 oder 3, dadurch gekennzeichnet, daß ein Lastwiderstand (R) am Ausgang der Gleichrichterstufe (D3,D4) vorgesehen ist.
